# EUROPÄISCHE PATENTANMELDUNG

(11) **EP 1 918 994 A1**
(43) Veröffentlichungstag der Anmeldung: **07.05.2008**
(21) Anmeldenummer: 07020670.1
(22) Anmeldetag: 23.10.2007
(51) Int. Cl.: H01L 27/142, H01L 31/18, H01L 31/0224

(54) **Verfahren zur Strukturierung eines Dünnschicht-Solarmoduls**

(30) Priorität: 02.11.2006 DE 102006051555
(71) Anmelder: Manz Automation AG, 72768 Reutlingen (DE)
(72) Erfinder: Manz, Dieter, 72667 Schlaitdorf (DE)
(74) Vertreter: Kohler Schmid Möbus

(57) **Zusammenfassung**

Ein Verfahren zur Strukturierung eines Dünnschicht-Solarmoduls (15), wobei auf ein Substrat (1) mehrere dünne Schichten (2, 4, 10) aufgebracht werden, und wobei in die dünnen Schichten (2, 4, 10) jeweils linienförmige Spuren (3, 5, 11) eingebracht werden, in denen das Material mindestens einer dünnen Schicht (2, 4, 10) wieder entfernt wird, ist dadurch gekennzeichnet, dass vor oder während des Einbringens einer neuen Spur (5, 11) der Verlauf einer vorhandenen Spur (3, 5) bestimmt wird, und dass beim Einbringen der neuen Spur (5, 11) der Verlauf der neuen Spur (5, 11) relativ zum Verlauf der vorhandenen Spur (3, 5) geregelt wird. Dadurch können Dünnschicht-Solarmodule mit verbessertem Wirkungsgrad hergestellt werden.

## Beschreibung

Die Erfindung betrifft ein Verfahren zur Strukturierung eines Dünnschicht-Solarmoduls, wobei auf ein Substrat mehrere dünne Schichten aufgebracht werden, und wobei in die dünnen Schichten jeweils linienförmige Spuren eingebracht werden, in denen das Material mindestens einer dünnen Schicht wieder entfernt wird.

Dünnschicht-Solarmodule weisen ein Substrat und typischerweise drei darauf abgeschiedene dünne Schichten auf. Die Dünnschicht-Solarmodule sind dabei in Struktureinheiten unterteilt, die voneinander durch Übergangsbereiche getrennt sind. In den Struktureinheiten findet bei Bestrahlung mit Licht die Trennung von Elektronen und Löchern statt (also die eigentliche Konversion von Licht in elektrische Energie), während mit den Übergangsbereichen die elektrische Verschaltung und Kontaktierung der Struktureinheiten erfolgt.

Dazu sind in den Übergangsbereichen Spuren (oder Gräben) erforderlich, in denen Material einer dünnen Schicht entfernt ist und gegebenenfalls durch ein anderes Material, etwa das Material einer darüber liegenden Schicht oder eines Leiters, etwa Silber, ersetzt ist. In den Übergangsbereichen liegen mehrere Spuren in einer bestimmten Abfolge nebeneinander (Satz von Spuren). Die nebeneinander liegenden Spuren dürfen sich nicht kreuzen, da sonst elektrische Kurzschlüsse auftreten können, die eine oder mehrere Struktureinheiten unbrauchbar machen würden.

Bei der Herstellung eines Dünnschicht-Solarmoduls wird üblicherweise auf einem planeren Substrat zunächst eine erste dünne Schicht vollflächig aufgebracht und anschließend strukturiert. Strukturieren meint hierbei das Einbringen von linienförmigen Spuren (oder Gräben) in die Schicht, d. h. das Material in der Spur wird entfernt. Die linienförmigen Spuren verlaufen bei diesem Einbringen gerade. Zur Strukturierung können beispielsweise ein mechanischer Stichel oder ein Laser eingesetzt werden. Anschließend wird eine zweite dünne Schicht vollflächig auf die erste Schicht aufgebracht, wobei auch die vorhandene Spur mit dem Material der neuen Schicht aufgefüllt wird. Nun erfolgt eine weitere Strukturierung, d. h. es werden neue, linienförmige Spuren eingebracht. Diese neuen Spuren haben beim Einbringen wiederum einen geraden Verlauf. Anschließend wird eine dritte dünne Schicht vollflächig abgeschieden und wiederum mit gerade verlaufenden Spuren strukturiert. Diese letzten Spuren werden üblicherweise mit einer Silberpaste befüllt. Zum Abschluss erfolgt in der Regel noch ein Tempern des Dünnschicht-Solarmoduls.

Bei jedem Abscheiden einer dünnen Schicht wird das Substrat erwärmt. Durch diese Erwärmung wird das Substrat dauerhaft verformt. Sofern auf dem Substrat bereits Strukturierungen vorhanden waren, werden infolge dieser Verformung vormals gerade verlaufende Spuren verzerrt, in der Regel bogenförmig. Um sicherzustellen, dass neu einzubringende Spuren nicht mit bereits vorhandenen Spuren infolge einer solchen Verzerrung überlappen oder gar kreuzen, werden zwischen den Sollpositionen der Spuren Sicherheitsabstände von ca. 100 - 200 µm eingehalten.

Die Sicherheitsabstände zwischen den Spuren verbreitern die Fläche der Übergangsbereiche und verringern somit die Fläche des Dünnschicht-Solarmoduls, die für die photoelektrisch aktiven Struktureinheiten zur Verfügung steht. Dadurch wird der Wirkungsgrad von Dünnschicht-Solarmodulen beschränkt.

### Aufgabe der Erfindung

Es ist die Aufgabe der vorliegenden Erfindung, ein Verfahren zur Strukturierung von Dünnschicht-Solarmodulen zur Verfügung zu stellen, mit dem Dünnschicht-Solarmodule mit verbessertem Wirkungsgrad hergestellt werden können.

### Kurze Beschreibung der Erfindung

Diese Aufgabe wird gelöst durch ein Verfahren der eingangs vorgestellten Art, das dadurch gekennzeichnet ist, dass vor oder während des Einbringens einer neuen Spur der Verlauf einer vorhandenen Spur bestimmt wird, und dass beim Einbringen der neuen Spur der Verlauf der neuen Spur relativ zum Verlauf der vorhandenen Spur geregelt wird.

Durch das erfindungsgemäße Verfahren wird eine aktive Kompensation der Verzerrung des Substrats und damit der Krümmung bereits vorhandener Spuren infolge der Erwärmung beim Abscheiden von oberen Schichten ermöglicht. Eine neue Spur wird typischerweise mit einem gekrümmten (nicht geraden) Verlauf eingebracht, der dem Verlauf einer bereits vorhandenen, benachbarten Spur im selben Übergangsbereich entspricht.

Der im Stand der Technik vorgesehene Sicherheitsabstand zwischen den Spuren verschiedener Schichtabscheidegenerationen muss so gewählt werden, dass der Abstand zwischen benachbarten Spuren auch an der engsten Stelle in elektrischer Hinsicht ausreichend ist. Über einem großen Teil der Erstreckung eines Übergangsbereichs liegt jedoch ein weit größerer Abstand vor, so dass unnötig Fläche des Dünnschicht-Solarmoduls verschwendet wird.

Mithilfe der Erfindung ist es im Gegensatz dazu möglich, benachbarte Spuren über den gesamten Übergangsbereich lediglich so eng zu beabstanden, wie es elektrisch (etwa aus Isolationsgründen) erforderlich ist. Ein zusätzlicher Sicherheitsabstand zur Vermeidung von Kreuzungen entfällt, wodurch die Fläche des Dünnschicht-Solarmoduls zu einem erhöhten Anteil für die lichtelektrische Konversion genutzt werden kann.

### Bevorzugte Varianten der Erfindung

Bei einer bevorzugten Variante des erfindungsgemäßen Verfahrens wird der Verlauf der neuen Spur so geregelt, dass ein konstanter Abstand zwischen der vorhandenen Spur und der neuen Spur eingestellt wird. Damit ergibt sich ein paralleler Verlauf benachbarter Spuren in einem Satz von Spuren in einem Übergangsbereich. Der konstante Abstand wird entsprechend den elektrischen Erfordernissen (etwa der nötigen Isolation zwischen den dünnen Schichten) gewählt. Damit lässt sich ein optimaler Wirkungsgrad des Dünnschicht-Solarmoduls erzielen.

In einer anderen, bevorzugten Verfahrensvariante wird der Verlauf der vorhandenen Spur als eine orthogonale Abweichung bezüglich einer gerade verlaufenden Hauptstrukturierungsrichtung bestimmt. Dies macht die Verlaufsbestimmung der vorhandenen Spur besonders einfach und erleichtert das parallele Nachfahren durch den Aufpunkt einer Strukturierungseinrichtung.

Besonders bevorzugt ist eine Verfahrensvariante, bei der die Bestimmung des Verlaufs der vorhandenen Spur optisch erfolgt. Dabei können sowohl Reflektions- als auch Transmissionseigenschaften des Substrats und bereits aufgebrachter dünner Schichten genutzt werden. Die optische Messung kann sowohl von der Unterseite des Substrats als auch von der beschichteten Oberseite des Substrats erfolgen. Die optische Bestimmung ist besonders kostengünstig.

Das Substrat kann mit einer oder mehreren Lichtquellen beleuchtet werden. Als Lichtquellen kommen beispielsweise LEDs oder Laser infrage. Insbesondere können mehrere Laser zur Spurdetektion eingesetzt werden. Dabei kann vorgesehen sein, dass zwei Messpunkte verwendet werden, in denen jeweils ein Messpunkt an der Kante einer vorher eingebrachten Spur erfasst wird. Alternativ ist es möglich, mehrere Messpunkte zu erfassen, wobei einer der Messpunkte innerhalb der Spur liegen sollte. Es können ein oder mehrere Detektoren zur Spurerfassung verwendet werden. Die Detektoren können eine ein-oder mehrdimensionale Erfassung ermöglichen. Beispielsweise können ein- oder mehrdimensionale Arrays oder CCD-Chips verwendet werden. Wenn ein eindimensionaler Detektor verwendet wird, kann vorgesehen sein, dass dieser drehbar ist, um eine Spur auch in einer anderen Richtung erfassen zu können.

Besonders bevorzugt ist es, wenn eine konvokale Abbildung erzeugt wird und aus der konvokalen Abbildung eine Tiefeninformation der vorhandenen Spur oder der momentan eingebrachten Spur erfasst wird. Insbesondere können Intensitätsschwankungen erfasst werden und auf eine vorgegebene Intensität geregelt werden.

Aus der Erfassung der Strahlformung kann eine Bewegungsrichtung ermittelt werden. Weiterhin ist es möglich, einen Leistungsgradienten zu erfassen und zu bewerten. Aus der konvokalen Abbildung kann außerdem ermittelt werden, ob das Substrat gewellt ist. In diesem Fall kann gegebenenfalls eine Nachfokussierung des Lasers, der eine Spur einbringt, erfolgen.

Es ist weiterhin denkbar, die Reflektion des strukturierenden Lasers zu erfassen. Dadurch ist es möglich, die Position zu erfassen, an der momentan eine Spur eingebracht wird. Insbesondere kann mit dem gleichen Detektor eine Spurerkennung erfolgen und die Position des Werkzeugs (des Lasers) bestimmt werden. Dadurch ist es möglich, die eingebrachte Spur gleichzeitig mit einer vorher eingebrachten Spur zu erfassen. Es kann dadurch der Abstand der Spuren ermittelt werden. Dadurch ist eine Qualitätskontrolle möglich. Außerdem kann der Abstand möglicherweise nachgeregelt werden.

Die Spurverfolgung der vorher eingebrachten Spur erfolgt vorzugsweise nicht scannend. Dies bedeutet, dass kein Abtasten quer zur Spurquerrichtung erfolgt. Es folgt lediglich möglicherweise eine Nachführung in Spurquerrichtung aufgrund einer Regelung. Eine scannende Erfassung einer bereits eingebrachten Spur kann möglicherweise zum Startpunkt stattfinden, um überhaupt die vorher eingebrachte Spur lokalisieren zu können. Die Spurverfolgung erfolgt jedoch nicht scannend.

Die durch einen Spurlagensensor erfassten Signale können aufbereitet werden und/oder direkt als Analogsignale einer Steuerung eines Strukturierungswerkzeugs, insbesondere eines Lasers, zugeführt werden. Die analogen Signale können weiterhin einer Hardware zugeführt werden und anschließend durch eine Software bearbeitet werden.

Wenn die Analogsignale unmittelbar der Steuerung des Lasers zugeführt werden, kann eine besonders schnelle Nachregelung bzw. Einstellung des Lasers erfolgen.

Eine vorteilhafte Weiterbildung dieser Verfahrensvariante sieht vor, dass eine Beleuchtung des Dünnschicht-Solarmoduls mit unterschiedlicher Wellenlänge erfolgt, wobei die Wellenlänge den Eigenschaften, insbesondere den Transmissions- und Reflektionseigenschaften der Materialien der durchstrahlten und/oder angestrahlten dünnen Schichten und gegebenenfalls des Substrats angepasst ist. Durch Wahl einer geeigneten Wellenlänge kann eine Spur in einer tiefer liegenden Schicht leicht optisch erkannt werden. Die Wellenlänge wird so gewählt, dass weiter oben liegende (d. h. sensornähere) Schichten durchstrahlt werden können (d. h. eine weiter oben liegende Schicht ist für die Wellenlänge transparent), jedoch ein Unterschied in Absorption oder Reflektion zwischen den Materialien, die am Rand einer zu detektierenden Spur aufeinander treffen, vorliegt. Die Wellenlänge wird für die Detektion von Spuren verschiedener Schichtabscheidegenerationen geeignet verändert, etwa durch Wechsel der Lichtquelle und erforderlichenfalls des Detektors.

Bevorzugt ist auch eine Variante des erfindungsgemäßen Verfahrens, bei der der Verlauf der vorhandenen Spur mit einem Spurlagensensor bestimmt wird, wobei der Spurlagensensor entsprechend dem bestimmten Verlauf der vorhandenen Spur nachgeführt wird. Hierbei kann die Position des Spurlagensensors zur Steuerung des Aufpunkts einer Strukturierungseinrichtung verwendet werden. Außerdem behält der Spurlagensensor einen gleich bleibend guten Blick auf die zu detektierende, vorhandene Spur. Man beachte, dass Spurlagensensor und Strukturierungseinrichtung auf der gleichen oder auch auf gegenüberliegenden Seiten des Substrats angeordnet sein können.

In einer vorteilhaften Weiterentwicklung dieser Verfahrensvariante ist vorgesehen, dass ein Aufpunkt einer Strukturierungseinrichtung, mit dem die Entfernung vom Material aus mindestens einer dünnen Schicht für das Einbringen der neuen Spur erfolgt, dem Spurlagensensor in einem definierten Abstand folgt. Dies vereinfacht die Steuerung des Materialabtrags, der am Aufpunkt erfolgt. Im Falle eines mechanischen Materialabtrags ist der Aufpunkt die Position des abrasiven Werkzeugs; im Falle eines Materialabtrags mittels Laserverdampfung ist der Aufpunkt der vom Laser ausgeleuchtete Bereich der dünnen Schicht.

In einer bevorzugten Verfahrensvariante erfolgt die Einbringung der linienförmigen Spuren mittels eines mechanischen Stichels. Der mechanische Materialabtrag ist besonders kostengünstig.

Bei einer ebenfalls bevorzugten, alternativen Verfahrensvariante erfolgt die Einbringung der linienförmigen Spuren mittels eines Laserstrahls, wobei insbesondere der Laserstrahl mit mindestens einem Umlenkspiegel auf eine gewünschte Position auf dem Dünnschicht-Solarmodul gelenkt wird. Der Materialabtrag mittels Laser ist besonders präzise. Durch den Umlenkspiegel können mechanische Bewegungen beim Materialabtrag auf ein Minimum, nämlich den oder die Umlenkspiegel, reduziert werden. Der oder die Umlenkspiegel werden bevorzugt mittels Piezoelementen ausgerichtet. Die Wellenlänge des Lasers wird so gewählt, dass eine Absorption (und somit ein Materialabtrag) nur in der oder den gewünschten dünnen Schichten stattfindet.

In den Rahmen der vorliegenden Erfindung fällt auch ein Dünnschicht-Solarmodul, hergestellt nach einem oben beschriebenen, erfindungsgemäßen Verfahren oder einer seiner Varianten. Das erfindungsgemäße Dünnschicht-Solarmodul kann eine deutlich höhere Energieausbeute je Fläche erreichten als herkömmliche Dünnschicht-Solarmodule.

Bevorzugt ist dabei eine Ausführungsform, bei der das Dünnschicht-Solarmodul mehrere Struktureinheiten aufweist, die voneinander durch Übergangsbereiche mit jeweils einem Satz von linienförmigen Spuren getrennt sind, wobei die linienförmigen Spuren eines Satzes zueinander parallel verlaufen. Mit den parallel verlaufenden Spuren in einem Übergangsbereich kann ein optimaler Wirkungsgrad erreicht werden.

Eine bevorzugte Weiterbildung dieser Ausführungsform sieht vor, dass die benachbarten Spuren eines Satzes einen Abstand von 60 µm oder weniger, gemessen in der Ebene des Substrats, aufweisen.

Weitere Merkmale und Vorteile der Erfindung ergeben sich aus der nachfolgenden detaillierten Beschreibung eines Ausführungsbeispiels der Erfindung anhand der Figur der Zeichnung, die erfindungswesentliche Einzelheiten zeigt, sowie aus den Ansprüchen. Die einzelnen Merkmale können je einzeln für sich oder zu mehreren in beliebigen Kombinationen bei Varianten der Erfindung verwirklicht sein.

### Zeichnung

Die Erfindung ist in der Zeichnung dargestellt und wird nachfolgend näher erläutert.

Es zeigen:
- Fig. 1a: einen schematischen Querschnittsausschnitt eines teilweise fertig gestellten erfindungsgemäßen Dünnschicht-Solarmoduls nach Aufbringung einer ersten dünnen Schicht und deren Strukturierung;
- Fig. 1b: eine schematische Aufsicht auf einen Teil des Dünnschicht- Solarmoduls von Fig. 1a;
- Fig. 2a: das Dünnschicht-Solarmodul gemäß Fig. 1a nach Aufbringung einer zweiten dünnen Schicht;
- Fig. 2b: eine schematische Draufsicht auf einen Teil des Dünnschicht-Solarmoduls von Fig. 2a;
- Fig. 3a: das Dünnschicht-Solarmodul gemäß Fig. 2a nach einer erfindungsgemäßen Strukturierung;
- Fig. 3b: eine schematische Draufsicht auf einen Teil des Dünnschicht-Solarmoduls von Fig. 3a;
- Fig. 3c: eine schematische Draufsicht auf einen Teil des Dünnschicht-Solarmoduls von Fig. 2a während des Strukturierens der zweiten dünnen Schicht;
- Fig. 4a: das Dünnschicht-Solarmodul von Fig. 3a nach Aufbringen einer dritten dünnen Schicht;
- Fig. 4b: eine schematische Draufsicht auf einen Teil des Dünnschicht-Solarmoduls von Fig. 4a;
- Fig. 5a: das Dünnschicht-Solarmodul von Fig. 4a nach einer erfindungsgemäßen Strukturierung;
- Fig. 5b: eine schematische Draufsicht auf einen Teil des Dünnschicht-Solarmoduls von Fig. 5a;
- Fig. 6a: eine schematische Draufsicht auf ein Substrat vor einer Temperierung;
- Fig. 6b: eine schematische Draufsicht auf das Substrat von Fig. 6a nach einer Temperierung.

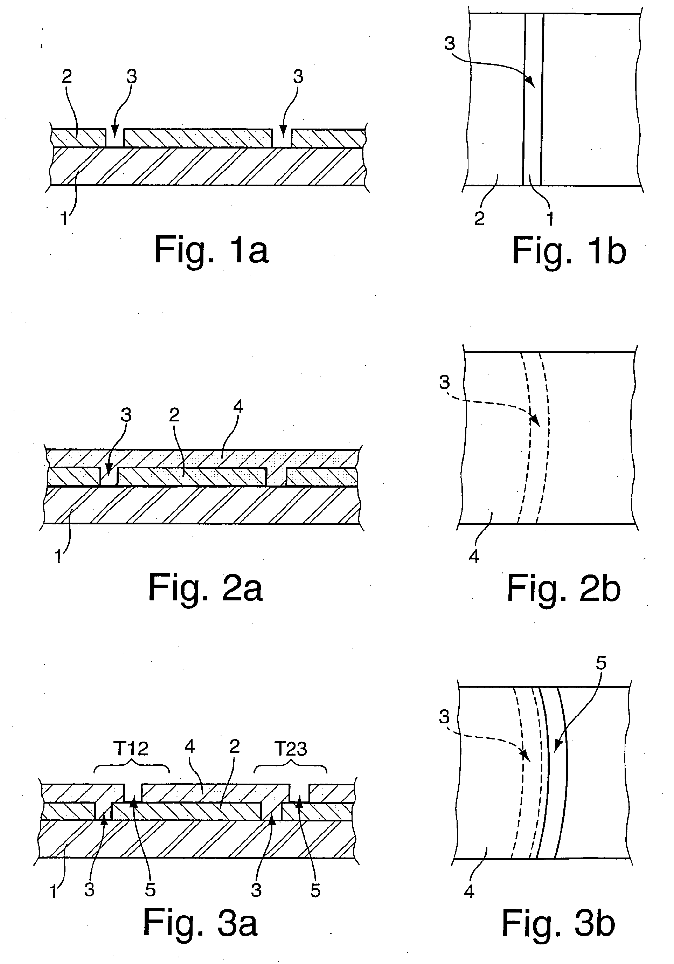

Die Figuren 1a bis 5b illustrieren den Ablauf der Herstellung eines Dünnschicht-Solarmoduls im Rahmen der vorliegenden Erfindung.

Die Figuren 1a und 1b zeigen im Querschnitt und in Draufsicht jeweils ein Substrat 1, welches typischerweise aus Glas (oder auch Metall oder Kunststoff) besteht, auf dem eine erste dünne Schicht 2 aufgebracht ist. Im Folgenden wird der Prozess anhand eines Schichtaufbaus eines möglichen amorphen Silizium-Dünnschichtmoduls erläutert. Diese erste dünne Schicht 2 ist in der Regel eine TCO(transparent conductive oxide)-Schicht. Diese Schicht wurde bereits mit gerade verlaufenden Spuren 3 strukturiert. Zur Vereinfachung ist in Fig. 1b nur eine der Spuren gezeichnet.

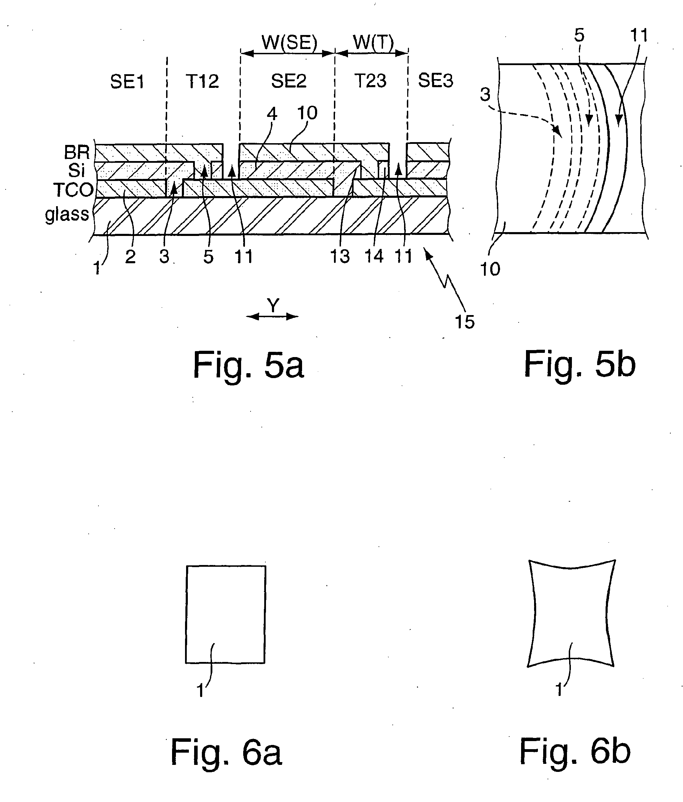

Auf diese erste Schicht 2 wird nun eine weitere dünne Schicht 4 aufgetragen, wie in Fig. 2a und 2b ersichtlich. Dabei wird das teilweise fertig gestellte Dünnschicht-Solarmodul erwärmen, wobei sich das Substrat 1 typischerweise dauerhaft verformen kann. Infolgedessen werden die vorhandenen Spuren 3 verformt und nehmen daraufhin (hier beispielhaft gezeigt) einen bogenförmigen Verlauf an (vgl. Fig. 2b). Die zweite dünne Schicht ist in der Regel eine Silizium-Schicht. Zur Verzerrung des Substrats 1 siehe auch Fig. 6a, 6b.

Die zweite dünne Schicht 4 wird nun strukturiert, vgl. Fig. 3a bis 3b. In der zweiten dünnen Schicht 4 wird in mehreren neuen Spuren 5 das Material der zweiten Spur 4 entfernt, beispielsweise mittels eines Laserstrahls. Dabei wird der Verlauf einer jeden neuen Spur 5 jeweils am Verlauf einer bereits vorhandenen Spur 3 orientiert, wobei die jeweilige vorhandene Spur 3 bevorzugt aus dem gleichen Satz von Spuren, d. h. aus dem gleichen Übergangsbereich, stammt wie die einzubringende neue Spur 5. In Fig. 3a sind beispielhaft zwei Übergangsbereiche T12 und T23 gezeigt (vgl. dazu auch Fig. 5a).

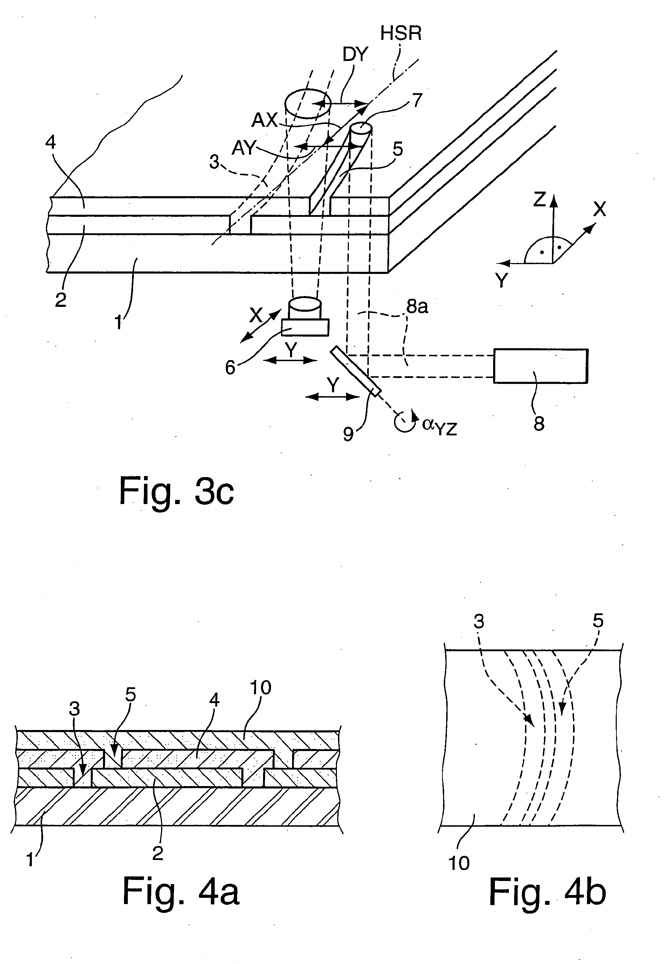

Die Einbringung der neuen Spuren 5 in die zweite dünne Schicht 4 wird anhand von Fig. 3c näher erläutert. In Fig. 3c ist zur Vereinfachung nur ein Übergangsbereich dargestellt, und der Abstand der Spuren 3, 5 ist übertrieben dargestellt.

Ein Spurlagensensor 6 detektiert den Verlauf der vorhandenen Spur 3 in der ersten dünnen Schicht 2. Die Spur 3 wird mit einer Wellenlänge beleuchtet, für die das Substrat 1 transparent ist und die andererseits einen Kontrast zwischen den Materialien der ersten und zweiten Schicht 2, 4 an den Rändern der Spur 3 von unten erkennbar macht. Dabei registriert der Spurlagensensor 6 den Verlauf der vorhandenen Spur 3 als eine Abweichung DY in einer γ-Richtung senkrecht zu einer geraden Hauptstrukturierungsrichtung HSR (die parallel zur x-Richtung verläuft). Der Spurlagensensor 6 wird unterhalb der vorhandenen Spur 3 verfahren. In der Praxis kann der Spurlagensensor 6 jeweils um eine kleine Strecke Δx in x-Richtung (Hauptstrukturierungsrichtung) vorgerückt werden, und sodann wird die Position der Spur 3 in γ-Richtung gemessen. Wenn der Spurlagensensor 6 eine relative Abweichung DY zur Spur 3 detektiert, kann dieser in γ-Richtung so verfahren werden, dass die Lage des Sensors 6 wieder unterhalb (in z-Richtung) der vorhandenen Spur 3 liegt. Dabei kann der Spurlagensensor 6 beispielsweise sich an bzw. mit einem der Ränder der vorhandenen Spur 3 orientieren und positionieren. Der Spurlagensensor 6 ist über geeignete Führungen (nicht dargestellt) in x- und γ-Richtung verfahrbar.

Über die Positionen in γ-Richtung des Spurlagensensors 6 im Laufe seines Voranschreitens in x-Richtung wird der Verlauf der vorhandenen Spur 3 bekannt. Parallel zur vorhandenen Spur 3 zeichnet ein Aufpunkt 7 eine der vorhandenen Spur 3 parallele, neue Spur 5 nach. Der Aufpunkt 7 ist der Bereich, in dem ein Materialabtrag (hier an der zweiten dünnen Schicht 4) erfolgt. Der Aufpunkt 7 wird von einer Strukturierungseinrichtung erzeugt. Die Strukturierungseinrichtung umfasst hier einen Laser 8, dessen Lichtstrahl 8a über einen Umlenkspiegel 9 zum Aufpunkt 7 gelenkt wird. Im vorliegenden Fall durchdringt der Laserstrahl 8a sowohl das Substrat 1 als auch die erste dünne Schicht 2 und wird erst an der zweiten dünnen Schicht 4 absorbiert, wodurch es zur Erhitzung und Verdampfung von Material der dünnen Schicht 4 kommt. Der Aufpunkt 7 läuft in x-Richtung in einem festen Abstand AX dem Spurlagensensor 6 nach, wobei auch ein fester Abstand AY in y-Richtung, bezogen auf die vormalige Position des Spurlagensensors 6 bei der derzeitigen x-Position des Aufpunkts 7, eingehalten wird. Der Aufpunkt 7 wird über die Verkippung und Verfahrung des Umlenkspiegels 9 gesteuert, beispielsweise piezoelektrisch mit Translation in γ-Richtung und Verkippung α_{yz} um eine Achse parallel der yz-Winkelhalbierenden.

Grundsätzlich werden im Rahmen der vorliegenden Erfindung alle neuen Spuren mit Hilfe einer Orientierung an vorhandenen Spuren erstellt. Man beachte, dass dabei auch mehrere neue Spuren gleichzeitig gefertigt werden können.

Alternativ zu einem Spurlagensensor ist auch eine photographische Aufnahme jeweils eines größeren Teils des teilweise fertig gestellten Dünnschicht-Solarmoduls denkbar, wobei diese Aufnahmen jeweils für das Verfahren des Aufpunkts sodann als Landkarte genutzt werden (nicht dargestellt).

Das weitere Vorgehen bei der Herstellung von Dünnschicht-Solarmodulen zeigen Fig. 4a und 4b. Auf die strukturierte zweite dünne Schicht 4 wird eine dritte dünne Schicht 10 vollflächig abgeschieden. Die dritte dünne Schicht 10 ist in der Regel eine metallische Schicht. Bei der Abscheidung der dritten Schicht 10 kann das Substrat 1 erneut verzerrt werden, z. B. durch eingebrachte Wärme beim Beschichtungsprozess. Dabei werden die vorhandenen Spuren 3, 5 aus verschiedenen Schichtabscheidegenerationen jedoch gleich stark betroffen.

Es schließt sich eine weitere Strukturierung an, d. h. es werden wiederum neue Spuren 11 in die dritte dünne Schicht 10 und hier auch in die zweite dünne Schicht 4 eingebracht, siehe Fig. 5a, 5b. Dabei wird erfindungsgemäß der Verlauf der neuen Spuren 11 am Verlauf der vorhandenen Spuren 3, 5 bevorzugt des gleichen Satzes von Spuren, d. h. des gleichen Übergangsbereichs T12, T23 orientiert. Da die vorhandenen Spuren 3, 5 eines Satzes zueinander parallel verlaufen, kann bei der Einbringung einer neuen Spur 11 sowohl die Spur 3 als auch die Spur 5 als Orientierung herangezogen werden. Im Ergebnis verlaufen die Spuren 3, 5, 11 eines Satzes von Spuren zueinander parallel.

An Fig. 5a kann der Aufbau eines erfindungsgemäßen Dünnschicht-Solarmoduls 15 aus Struktureinheiten SE1, SE2, SE3 und Übergangsbereichen T12, T23 ersehen werden. In den Struktureinheiten SE1, SE2, SE3 findet die Erzeugung von elektrischer Energie bei Lichteinstrahlung statt, während die Übergangsbereiche T12, T23 der elektrischen Verbindung der Struktureinheiten dienen und nicht photoelektrisch aktiv sind. Im Rahmen der Erfindung ist es möglich, Isolationsbereiche 13, 14 zwischen den Spuren 3, 5, 11 (d. h. den Abstand der Spuren) auf die elektrisch notwendige, minimale Breite (in γ-Richtung) zu beschränken. Somit kann das Verhältnis der Breiten der Struktureinheiten W(SE) zu den Breiten der Übergangsbereiche W(T), also W(SE)/W(T) vergrößert werden. Dies steigert den Wirkungsgrad des Dünnschicht-Solarmoduls 15. Typische Breiten von Spuren 3, 5, 11 betragen je ca. 40 - 50 µm, und die Breite der Struktureinheiten beträgt typischerweise je ca. 3-12 mm, wobei auf einem Dünnschicht-Solarmodul eine Vielzahl (>10) von Struktureinheiten nebeneinander angeordnet sind. Mit Hilfe der Erfindung kann die Breite der Isolationsbereiche 13, 14 auf konstant je ca. 5 - 20 µm reduziert werden, wohingegen im Stand der Technik Breiten der Isolationsbereiche bzw. Sicherheitsabstände von je 40 - 200 µm eingehalten werden müssen.

Man beachte, dass im Rahmen der Erfindung auch Achsfehler von Bearbeitungmaschinen beim Einbringen von Strukturen (etwa der ersten Spur 3) ausgeglichen werden.

In den Figuren 6a und 6b ist ergänzend ein ganzes Substrat 1, wie es für ein Dünnschicht-Solarmodul verwendet wird, in Draufsicht gezeigt, in Fig. 6a vor und in Fig. 6b nach einer Erwärmung, wie sie bei einer Abscheidung einer dünnen Schicht erfolgt. Nach der Erwärmung ist das Substrat 1 typischerweise kissenartig verzogen; dieser Verzug bleibt auch nach Abkühlung erhalten. Infolgedessen werden auch Strukturen und Spuren, die bereits auf dem Substrat 1 aufgebracht waren, verzerrt. Die Verzerrung ist umso stärker, je weiter außen (d. h. vom Zentrum des Substrats 1 weg) die Struktur oder Spur liegt.

In den Figuren sind die Verformungen infolge Erwärmung nicht maßstäblich, sondern übertrieben dargestellt.

## Patentansprüche

1. Verfahren zur Strukturierung eines Dünnschicht-Solarmoduls (15), wobei auf ein Substrat (1) mehrere dünne Schichten (2, 4, 10) aufgebracht werden, und wobei in die dünnen Schichten (2, 4, 10) jeweils linienförmige Spuren (3, 5, 11) eingebracht werden, in denen das Material mindestens einer dünnen Schicht (2, 4, 10) wieder entfernt wird, **dadurch gekennzeichnet, dass** vor oder während des Einbringens einer neuen Spur (5, 11) der Verlauf einer vorhandenen Spur (3, 5) bestimmt wird, und dass beim Einbringen der neuen Spur (5, 11) der Verlauf der neuen Spur (5, 11) relativ zum Verlauf der vorhandenen Spur (3, 5) geregelt wird.

2. Verfahren nach Anspruch 1, **dadurch gekennzeichnet, dass** der Verlauf der neuen Spur (5, 11) so geregelt wird, dass ein konstanter Abstand (AY) zwischen der vorhandenen Spur (3, 5) und der neuen Spur (5, 11) eingestellt wird.

3. Verfahren nach einem der vorhergehenden Ansprüche, **dadurch gekennzeichnet, dass** der Verlauf der vorhandenen Spur (3, 5) als eine orthogonale Abweichung (DY) bezüglich einer gerade verlaufenden Hauptstrukturierungsrichtung (HSR) bestimmt wird.

4. Verfahren nach einem der vorhergehenden Ansprüche, **dadurch gekennzeichnet, dass** die Bestimmung des Verlaufs der vorhandenen Spur (3, 5) optisch erfolgt.

5. Verfahren nach Anspruch 4, **dadurch gekennzeichnet, dass** eine Beleuchtung des Dünnschicht-Solarmoduls (15) mit einer definierten Wellenlänge erfolgt, wobei die Wellenlänge den Eigenschaften, insbesondere den Transmissions- und Reflektionseigenschaften, der Materialien der durchstrahlten und/oder angestrahlten dünnen Schichten (2, 4, 10) und gegebenenfalls des Substrats (2) angepasst ist.

6. Verfahren nach einem der vorhergehenden Ansprüche, **dadurch gekennzeichnet, dass** der Verlauf der vorhandenen Spur (3, 5) mit einem Spurlagensensor (6) bestimmt wird, wobei der Spurlagensensor (6) entsprechend dem Verlauf der vorhandenen Spur (3, 5) nachgeführt wird.

7. Verfahren nach Anspruch 6, **dadurch gekennzeichnet, dass** ein Aufpunkt (7) einer Strukturierungseinrichtung, mit der die Entfernung von Material aus mindestens einer dünnen Schicht (2, 4, 10) für das Einbringen der neuen Spur (5, 11) erfolgt, dem Spurlagensensor (6) in einem definierten Abstand (AX) folgt.

8. Verfahren nach einem der vorhergehenden Ansprüche, **dadurch gekennzeichnet, dass** das die Einbringung der linienförmigen Spuren (3, 5, 11) mittels eines mechanischen Stichels erfolgt.

9. Verfahren nach einem der vorhergehenden Ansprüche, **dadurch gekennzeichnet, dass** die Einbringung der linienförmigen Spuren (3, 5, 11) mittels eines Laserstrahls (8a) erfolgt, wobei insbesondere der Laserstrahl (8a) mit mindestens einem Umlenkspiegel (9) auf eine gewünschte Position auf dem Dünnschicht-Solarmodul (15) gelenkt wird.

10. Dünnschicht-Solarmodul (15), hergestellt nach einem Verfahren gemäß einem der vorhergehenden Ansprüche.

11. Dünnschicht-Solarmodul (15) gemäß Anspruch 10, **dadurch gekennzeichnet, dass** das Dünnschicht-Solarmodul (15) mehrere Struktureinheiten (SE1, SE2, SE3) aufweist, die voneinander durch Übergangsbereiche (T12, T23) mit jeweils einem Satz von linienförmigen Spuren (3, 5, 11) getrennt sind, wobei die linienförmigen Spuren (3, 5, 11) eines Satzes zueinander parallel verlaufen.

12. Dünnschicht-Solarmodul (15) nach Anspruch 11, **dadurch gekennzeichnet, dass** die benachbarten Spuren (3, 5, 11) eines Satzes einen Abstand von 60 µm oder weniger, gemessen in der Ebene (xy) des Substrates (1), aufweisen.
